# EUROPÄISCHE PATENTSCHRIFT

(11) **EP 1 701 386 B1**
(45) Veröffentlichungstag und Bekanntmachung des Hinweises auf die Patenterteilung: **02.04.2008**
(21) Anmeldenummer: 06003874.2
(22) Anmeldetag: 25.02.2006
(51) Int. Cl.: H01L 27/082, H01L 27/06, H01L 21/822

(54) **Verfahren zur Integration von zwei Bipolartransistoren in einem Halbleiterkörper, Halbleiteranordnung in einem Halbleiterkörper und Kaskodenschaltung**
Method for integration of two bipolar transistors on an semiconductor substrate, semiconductor structure in an semiconductor body and an cascode circuit
Méthode pour l'intégration de deux transistors bipolaires sur un substrat semi-conducteur, structure semi-conductrice dans un semi-conducteur et circuit cascode

(30) Priorität: 03.03.2005 DE 102005009725
(43) Veröffentlichungstag der Anmeldung: 13.09.2006
(73) Patentinhaber: ATMEL Germany GmbH, 74072 Heilbronn (DE)
(72) Erfinder: Bromberger, Christoph, Dipl.-Phys., 74074 Heilbronn (DE)
(74) Vertreter: Müller, Wolf-Christian

(56) Entgegenhaltungen:
- US-A- 4 651 410
- US-A- 4 717 681
- US-A- 4 771 013
- US-A- 5 037 774
- U. TIEZE, CH. SCHENK: "Halbleiter-Schaltungstechnik" 1976, SPRINGER-VERLAG , BERLIN , XP002376337 ISBN: 3-540-06667-5 * Seite 112 - Seite 113 *

## Beschreibung

Die vorliegende Erfindung betrifft ein Verfahren zur Integration von zwei Bipolartransistoren in einen Halbleiterkörper und eine Halbleiteranordnung in einem Halbleiterkörper.

Aus der Druckschrift EP 0 493 854 sind vertikal integrierte Kaskodenstrukturen mit zwei Transistoren für Hochvoltanwendungen bekannt. Hierbei wird ein geometrisch untenliegender Transistor mit einer hohen Sperrfähigkeit mit einem geometrisch obenliegenden Transistor vertikal integriert. Derartige Anordnungen werden vorzugsweise im Spannungsbereich über 100 V eingesetzt. Die Emitterregion des geometrisch untenliegenden Transistors weist, bei demselben Leitungstyp, eine deutlich höhere Dotierstoffkonzentration auf als eine angrenzende Kollektor-Driftzone des geometrisch obenliegenden Transistors. Hierdurch wird insbesondere die Emitter-Effektivität des geometrisch untenliegenden Transistors erhöht. Die vertikale Integration beispielsweise zweier npn-Transistoren ergibt einen parasitären pnp-Transistor, so dass die Anordnung aus EP 0 493 854 zu thyristorähnlichem Verhalten neigt und der Kollektorstrom nur eingeschränkt steuerfähig bleibt.

In der Druckschrift EP 605 920 wird die Neigung der Anordnung aus EP 0 493 854 zu thyristorähnlichem Verhalten über eine Erhöhung der Gummelzahl G_{B} des parasitären Transistors verringert. Hierzu wird die Emitterregion des unteren Transistors als hochdotierte Schicht ausgeführt, die die Basis des unteren Transistors von der Kollektor-Driftzone des oberen Transistors durchgehend voneinander trennt, indem eine MESA (Tafelberg)-Struktur erzeugt wird. In der EP 605 920 sind ausschließlich zwei Transistoren in die MESA (Tafelberg)-Struktur integrierbar. In einer weiteren Ausführungsform wird in EP 605 920 p-dotiertes SiGe als Ätzstopp für die Herstellung der MESA-Struktur in der Basis des unteren Transistors verwendet.

Aus der US 4,651,410 ist ein Fabrikationsverfahren zur Ausbildung von Regionen eines integrierten Mikrowellen-Bipolartransistors bekannt. Aus der US 5,037,774 ist ein Herstellungsprozess für ein Halbleiterbauelement bekannt, der eine Mehrfach-Deposition und Rekristallisation von amorphem Silizium verwendet. Aus der US 4,771,013 oder der US 4,717,681 ist ein dreidimensionaler Bipolar Herstellungsprozess bekannt. Hierzu werden sequenzielle Epitaxieschritte in einem UHV siliziumbasierten MBE-Apparat durchgeführt.

Aus der US 6,338,991 B1 ist ein Verfahren bekannt, indem eine SiO₂-Schicht von einer amorphen Siliziumschicht überdeckt wird und diese amorphe Siliziumschicht lateral zu einer monokristallinen Halbleiterschicht kristallisiert wird. Als Kristallisationskeime wirken Silizid-Insel, wobei sich lediglich oberhalb der Si02-Schicht eine nutzbare monokristalline Halbleiterschicht ausbildet, so dass die Silizid-Inseln mit samt dem angrenzenden polykristallinen Silizium geätzt werden müssen. Hingegen bilde ein homogen auf dem Substrat aufgebrachtes Metall eine unbegrenzte Anzahl von Kristallisationsstartpunkten, so dass nur schwer ein Film mit guten Kristalleigenschaften zu erzeugen sei.

Aufgabe der vorliegenden Erfindung ist es, ein weiterentwickeltes Verfahren zur Integration einer Halbleiteranordnung anzugeben, um die Hochfrequenzeigenschaften der Halbleiteranordnung möglichst zu verbessern.

Diese Aufgabe wird erfindungsgemäß durch ein Verfahren zur Integration von zwei Bipolartransistoren in einen Halbleiterkörper mit den Merkmalen des Patentanspruchs 1 und durch eine Halbleiteranordnung in einem Halbleiterkörper mit den Merkmalen des Patentanspruchs 11 gelöst.

Vorteilhafte Weiterbildungen der Erfindung sind Gegenstand von Unteransprüchen.

Demzufolge werden in einem Verfahren zur Integration von zwei Bipolartransistoren in einen Halbleiterkörper zunächst für den ersten Bipolartransistor ein erstes Emitterhalbleitergebiet, ein erstes Basishalbleitergebiet und ein erstes Kollektorhalbleitergebiet erzeugt.

Auf den ersten Bipolartransistor wird eine Rekombinationsschicht aufgebracht, die an das erste Emitterhalbleitergebiet oder das erste Kollektorhalbleitergebiet grenzt und zur Rekombination von Ladungsträgern an der Rekombinationsschicht ausgebildet ist.

Eine Silizidschicht oder eine Metallschicht wird als Rekombinationsschicht formiert. Nachfolgend wird eine amorphe Halbleiterschicht sowohl auf der Rekombinationsschicht als auch auf einen offen liegenden, an die Rekombinationsschicht angrenzenden, monokristallinen Halbleiterbereich aufgebracht.

In einer nachfolgenden Temperaturbehandlung wird die amorphe Halbleiterschicht ausgehend von dem als Kristallisationskeim wirkenden, offen liegenden, monokristallinen Halbleiterbereich kristallisiert, so dass die Rekombinationsschicht zumindest teilweise durch eine kristallisierte, monokristalline Halbleiterschicht bedeckt wird.

Nachfolgend wird auf die Rekombinationsschicht der zweite Bipolartransistor angeordnet, indem ein zweites Emitterhalbleitergebiet, ein zweites Basishalbleitergebiet und ein zweites Kollektorhalbleitergebiet auf der Rekombinationsschicht erzeugt werden, so dass das zweite Emitterhalbleitergebiet oder das zweite Kollektorhalbleitergebiet an die Rekombinationsschicht grenzt.

Untersuchungen der Anmelderin haben ergeben, dass es entgegen dem herrschenden Vorurteil möglich ist, ohne aufwendige Verfahren, wie
- ein Verfahren, auf bestimmte, zu Silizium gitterangepasste Silizide wie ErSi₂ oder CoSi₂ per Molekularstrahlepitaxie monokristalline Siliziumschichten aufzuwachsen; oder
- ein Verfahren, Schichten aufzuwachsen, die aus einer das Kristallgitter des Substrates epitaktisch fortsetzenden Matrix bestehen, in die in einer dünnen Schicht nicht gitterangepasste Silizid-Kristallite eingelagert werden, welche Kristallite sich durch eine nachfolgende Temperung zu einer durchgehenden Silizidschicht zusammenfügen;
auf Silizidschichten monokristalline Halbleitergebiete aufzubringen.

In einer beispielhaften Ausgestaltung der Erfindung wird die Silizidschicht aus Titan als Übergangsmetall und Silizium als Halbleitermaterial gebildet.

Zwar ist grundsätzlich eine bezüglich der Waferoberfläche ausschließlich vertikale Kristallisationsrichtung möglich, in einer bevorzugten Ausgestaltung der Erfindung wird die amorphe Halbleiterschicht zumindest auch lateral kristallisiert. Dies kann natürlich mit einer vertikalen Kristallisationsrichtung vorteilhaft kombiniert werden.

Eine besonders bevorzugte Weiterbildung der Erfindung sieht vor, dass die Kristallisation in einem Temperaturbereich zwischen 400°C und 600°C erfolgt. Vorteilhafterweise ist die Temperatur im Prozess dabei von dem verwendeten Silizid abhängig. Vorteilhafterweise ist die Temperatur dabei so gewählt, dass Metallionen der Silizidschicht die angrenzende monokristalline Halbleiterschicht für die maßgebliche Funktion dieser Halbleiterschicht nicht signifikant verunreinigen, beziehungsweise die Keimbildungsrate in der angewachsenen amorphen Halbleiterschicht nicht wesentlich erhöhen.

Vorteilhafterweise wird die amorphe Siliziumschicht mit einer Schichtdicke von mindestens 300 nm aufgebracht, wobei vorzugsweise zumindest ein Bereich der amorphen Halbleiterschicht mit zumindest einem Dotierstoff, insbesondere mit Germanium, Phosphor, Bor und/oder Arsen dotiert wird, um das Kristallwachstum und die Keimbildungsrate im Herstellungsprozess zu steuern. In einer vorteilhaften Ausgestaltung der Erfindung ist dabei vorgesehen, dass der Dotierstoff in einen vorzugsweise 250 nm dicken Oberflächenbereich der amorphen Siliziumschicht insbesondere durch Implantation eingebracht wird. Um diesen für die Funktion störenden hochdotierten Bereich wieder zu entfernen ist in einer vorteilhaften Weiterbildung der Erfindung vorgesehen, dass mit dem Dotierstoff dotierte Bereiche der kristallisierten, monokristallinen Halbleiterschicht selektiv, insbesondere nasschemisch geätzt werden, indem die mit dem Dotierstoff dotierten Bereiche eine gegenüber einem geringer dotierten Bereich der kristallisierten, monokristallinen Halbleiterschicht höhere Ätzrate aufweisen.

Um insbesondere weitere aktive Bereiche eines Bauelementes zu erzeugen ist in einer vorteilhaften Weiterbildung der Erfindung vorgesehen, dass vorzugsweise nach dem Entfernen der nicht-monokristallinen Bereiche der Halbleiterschicht die monokristalline Schicht durch Epitaxie, insbesondere durch selektive vertikale Epitaxie, verdickt wird. Dies dient dazu, Halbleitergebiete des zweiten Bipolartransistors auszubilden, indem insbesondere während die Epitaxie die Dotierstoffe insitu eingebracht werden.

Mittels der verdickenden Epitaxie können mehrere unterschiedliche Halbleiterschichten aus unterschiedlichen Halbleitermaterialien, wie Si oder SiGe aufgebracht werden. Vorzugsweise sind zudem Halbleiterbereiche mit unterschiedliche Leitungstypen, n-leitend oder p-leitend zur Bildung von pn-Übergängen des Bipolartransistors vorgesehen.

Wird eine Metallschicht als Rekombinationsschicht verwendet, wird im Integrationsverfahren eine Metallschicht, insbesondere aus Molybdän als Rekombinationsschicht aufgebracht. Danach wird eine amorphe Halbleiterschicht sowohl auf der Metallschicht, als auch auf einen offen liegenden, an die Metallschicht angrenzenden, monokristallinen Halbleiterbereich aufgebracht.

In einer nachfolgenden Temperaturbehandlung wird die amorphe Halbleiterschicht ausgehend von dem als Kristallisationskeim wirkenden, offen liegenden, monokristallinen Halbleiterbereich kristallisiert, so dass die Metallschicht zumindest teilweise durch eine kristallisierte, monokristalline Halbleiterschicht bedeckt wird. Molybdänverunreinigung bewirken dabei nur eine geringe Erhöhung der Keimbildungsrate. Zudem ist die Silizidierungstemperatur (~1000 °C) von Molybdän höher als die Temperatur während der Temperaturbehandlung der amorphen Halbleiterschicht.

Ein weiter Aspekt der Erfindung betrifft eine Halbleiteranordnung in einem Halbleiterkörper mit einem ersten Bipolartransistor und einem zweiten Bipolartransistor, die bezüglich der Oberfläche des Halbleiterkörpers vertikal übereinander angeordnet sind.

Dabei grenzen ein Emitterhalbleitergebiet des ersten Bipolartransistors und ein Kollektorhalbleitergebiet des zweiten Bipolartransistors an eine Rekombinationsschicht, die zur Rekombination von Ladungsträgern an den Grenzflächen zum Emitterhalbleitergebiet und/oder zum Kollektorhalbleitergebiet ausgebildet ist.

Die Rekombinationsschicht ist eine Metallschicht, die von einer monokristalllinen Halbleiterschicht bedeckt ist, welche ausgehend von einem als Kristallisationskeim wirkenden, offen liegenden, monokristallinen Halbleiterbereich kristallisiert ist.

Eine bevorzugte Weiterbildung dieses Aspekts der Erfindung sieht vor, dass zumindest bereichsweise zumindest ein erster PN-Übergang des ersten Bipolartransistors parallel zu zumindest einem zweiten PN-Übergang des zweiten Bipolartransistors ausgebildet ist. Vorzugsweise sind sämtliche PN-Übergänge zumindest bereichsweise parallel zueinander ausgebildet.

In einer Weiterbildung ist eine Kaskodenschaltung vorgesehen, die vorzugsweise zur Verstärkung von Hochfrequenzsignalen ausgebildet ist. Diese Kaskodenschaltung weist den ersten Bipolartransistor in Emitterschaltung und den zweiten Bipolartransistor in Basisschaltung auf.

Dabei ist ein Kollektorhalbleitergebiet des ersten Bipolartransistors durch die Rekombinationsschicht von einem Emitterhalbleitergebiet des zweiten Bipolartransistors getrennt. Der erste Bipolartransistor und der zweite Bipolartransistor sind vertikal übereinander integriert, so dass beide im Wesentlichen die selbe Grundfläche des Halbleitersubstrats belegen.

Vorteilhafterweise ist die Rekombinationsschicht über eine elektrisch leitfähige Verbindung mit zumindest einem Anschluss der Bipolartransistoren, einem weiteren integrierten Bauelement und/oder mit einem Anschluss der Kaskodenschaltung verbunden. Dies ermöglicht beispielsweise, das Potential der Rekombinationsschicht festzulegen oder einen Strom in die Rekombinationsschicht einzuspeisen.

Die Halbleiteranordnung oder die Kaskodenschaltung können als höchstfrequenztaugliches aktives Bauelement, in einem Frequenzbereich, in dem das transiente Verhalten wesentlich durch den Miller-Effekt beeinflusst wird oder als hochsperrendes aktives Bauelement, in einem Spannungsbereich, in dem das transiente Verhalten wesentlich von der Laufzeit durch die Raumladungszone zwischen dem Kollektor und der Basis zumindest eines Transistors bestimmt ist, verwendet werden.

Im Folgenden wird die Erfindung anhand eines zeichnerisch dargestellten Ausführungsbeispiels näher erläutert.

Dabei zeigen
- Fig. 1: eine schematische Schnittdarstellung einer Halbleiteranordnung, und
- Fig. 2: eine schematische Schnittdarstellung nach mehreren Herstellungsschritten und Aufbringen einer Rekombinationsschicht.

In einem Halbleiter könne Elektron-Loch-Paare auf verschiedene Weise injiziert werden. Unabhängig von der Methode der Injektion rekombinieren diese Ladungsträger mit einer Rate, die bei kleinen Zusatzkonzentrationen proportional ihrer augenblicklichen Konzentration ist. Der daraus resultierende exponentielle Abfall der injizierten, überschüssigen Ladungsträger läuft mit einer Zeitkonstante ab, die als Ladungsträger-Lebensdauer definiert ist.

Die injizierten Elektron-Loch-Paare tragen aufgrund elektrischer und magnetischer Felder oder ihres eigenen Konzentrationsgradienten zu einer Trägerbewegung, also zum elektrischen Strom bei, was mit einer Erhöhung der Leitfähigkeit verbunden ist. Während dieser Trägerbewegung rekombinieren sie entweder direkt (Band-Band) oder durch Rekombinationszentren wie Störstellen, Gitterfehlstellen usw. im Halbleiter oder an einer seiner Oberflächen oder Grenzflächen zu anderen Materialien.

Vorzugsweise Fremstoffe, die in einem Halbleiter zu Störstellen führen, die in etwa in der Mitte des Bänderschemas liegen, wirken als Rekombinationszentren und haben einen Einfluss auf die Lebensdauer der Ladungsträger. Da die Rekombinationsrate durch denjenigen Ladungsträgertyp bestimmt wird, dessen Konzentration am geringsten ist, erfolgt der Abfall der Überschussladungsträger-Konzentration durch die Rekombination der Minoritätsträger im jeweiligen Halbleitergebiet.

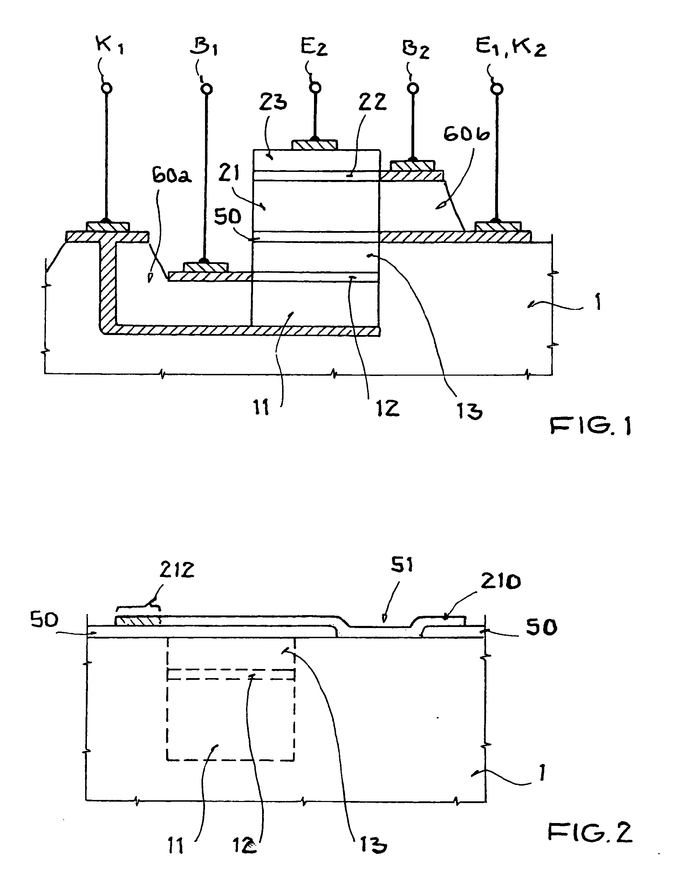

In Fig. 1 ist eine Schnittansicht durch eine Halbleiteranordnung dargestellt. In ein monokristallines Siliziumsubstrat 1 ist eine Kaskodenanordnung mit zwei Bipolartransistoren integriert. Der erste Transistor weist dabei ein erstes Kollektorhalbleitergebiet 11, eine erstes Basishalbleitergebiet 12 und eine Emitterhalbleitergebiet 13 auf. Der zweite Transistor weist analog ein zweites Kollektorhalbleitergebiet 21, ein zweites Basishalbleitergebiet 22 und ein zweites Emitterhalbleitergebiet 23 auf. In der Fig. 1 sind zur Vereinfachung die Halbleitergebiete 11, 12, 13, 21, 22 und 23 gleich-strukturiert dargestellt.

Zwischen dem ersten Emitterhalbleitergebiet 13 und dem zweiten Kollektorhalbleitergebiet 21 ist eine Rekombinationsschicht 50 als Rekombinationszentrum für Ladungsträger des ersten Emitterhalbleitergebietes 13 und des zweiten Kollektorhalbleitergebietes 21 angeordnet. Diese Rekombinationsschicht 50 ist beispielsweise eine Silizidschicht oder eine Metallschicht, die sowohl an das erste Emitterhalbleitergebiet 13, als auch an das zweite Kollektorhalbleitergebiet 21, unmittelbar angrenzt.

Weiterhin sind in Fig. 1 schematisch die Anschlüsse der durch die Halbleiteranordnung gebildeten vertikal integrierten Kaskode dargestellt. Dabei können der erste Transistor über den ersten Kollektoranschluss K1 und den ersten Basisanschluss B1 angeschlossen werden. Die Gebiete 60a und 60b können hierbei beispielsweise in Si02 ausgeführt sein. Über den Anschluss E1K2 der Rekombinationsschicht 50 ist ebenfalls des erste Kollektor und zwingend gekoppelt der zweite Emitter anschließbar. Die weiteren Anschlüsse des zweiten Transistors sind der zweite Basisanschluss B2 und der zweite Emitteranschluss E2.

Fig. 2 zeigt schematisch ein Zwischenstadium der Herstellung einer Halbleiteranordnung der Fig. 1. In das monokristalline Halbleitersubstrat 1 sind das erste Kollektorhalbleitergebiet 11, das erste Basishalbleitergebiet 12 und das erste Emitterhalbleitergebiet 13 beispielsweise durch Implantation oder epitaktisches Aufwachsen bereits eingebracht. Auf die Oberfläche des Halbleitersubstrats 1 ist eine Silizidschicht als Rekombinationsschicht 50 formiert. In diese Silizidschicht ist eine Öffnung 51 eingebracht, so dass ein Oberflächenbereich des monokristallinen Substrats 1 oder einer, nicht dargestellten, epitaktische aufgebrachten, monokristallinen Halbleiterschicht freiliegt. Auf diese Öffnung 51 und auf die Silizidschicht ist eine Schicht aus amorphen Silizium aufgebracht, die nachfolgend zu einer monokristallinen Siliziumschicht 210 kristallisiert wird.

Bei der Kristallisation amorpher Substanzen beeinflussen zwei temperaturabhängige Größen, die Keimbildungsrate und die Kristallwachstumsgeschwindigkeit, die Qualität und die Eigenschaften der kristallisierten Schicht 210. Wenn sich auf einer Schicht bereits polykristalline Körner gebildet haben, kommt eine von Kristallisationskeimen ausgehende, laterale Festphasenepitaxie an den Korngrenzen zum Stillstand. Mit undotiertem amorphen Si lassen sich so etwa 4 µm lateral, monokristallin und mit guter Kristallqualität überwachsen. Es ist dabei möglich, dass die laterale Ausdehnung des monokristallinen Bereichs etwa 10 mal die Schichtdicke beträgt. Mit hoch Phosphor-, Bor- oder Germanium-dotierten amorphen Silizium kann dagegen zwischen 20 µm und 40 µm überwachsen werden. Durch selektives Ätzen einer hochdotierten Schicht lassen sich so darüber hinaus auch dünnere Schichten aus kristallisiertem amorphen Silizium bilden.

Übergangsmetallverunreinigungen, vor allem solche mit Nickel, erhöhen die Kristallbildungsrate von Silizium bei niedrigen Temperaturen. Die Dotierung mit Übergangsmetallen kann beispielsweise zur Herstellung von Dünnschichttransistoren genutzt werden. Wenn somit in nennenswertem Maße freie Metall-Ionen aus einer Silizidschicht in aufliegendes amorphes Silizium eindiffundieren, erscheint ein Überwachsen von Silizidschichten mit der lateralen Festphasenepitaxie von Silizium unmöglich.

Jedoch gibt es für Vielzahl von Siliziden einen Temperaturbereich, in dem die laterale Festphasenepitaxie, ausgehend von einer auch als Kristallisationskeim bezeichneten Saatöffnung 51 zu einer Kristallwachstumsrate führt, während zugleich die Ausdiffusion der Übergangsmetallionen aus der Silizidschicht in die aufliegende Siliziumschicht 210 derart gering ist, dass nicht in prohibitiy hohem Maße die Kristallisationsrate erhöht ist.

Die laterale Festphasenepitaxie erfolgt dabei in einem Temperaturbereich zwischen 400°C und 600°C, der entsprechend einer geringen Rate der Diffusion von Übergangsmetallen aus der Silizidschicht in eine kristallisierte, monokristalline Halbleiterschicht 210, die beispielsweise aus Si oder SiGe besteht, gewählt ist. Die durch die Festphasenepitaxie erhaltene kristallisierte, monokristalline Halbleiterschicht 210 bedeckt dabei das verfüllte Saatfenster 51 wie auch angrenzende Bereiche der Silizidschicht. Die kristallisierte, monokristalline Halbleiterschicht 210 endet jedoch an polykristallinen Bereichen 212, die durch spontane Kristallbildung aus der amorphen Siliziumschicht von dem Saatfenster 51 entfernt entstanden sind.

In nachfolgenden, nicht dargestellten Schritten werden die polykristallinen Bereiche 212 beispielsweise durch eine entsprechende Maskierung und anschließende Trockenätzung entfernt. Die kristallisierte, nun monokristalline Siliziumschicht 210 wird durch weiteres epitaktisches Aufbringen von Silizium gedickt und hierbei oder nachfolgend die Halbleitergebiete 21, 22 und 23 des zweiten Bipolartransistors gebildet.

## Patentansprüche

1. Verfahren zur Integration von zwei Bipolartransistoren in einen Halbleiterkörper (1), indem
- für den ersten Bipolartransistor
a) ein erstes Emitterhalbleitergebiet (13),
b) ein erstes Basishalbleitergebiet (12) und
c) ein erstes Kollektorhalbleitergebiet (11) erzeugt wird,
- auf den ersten Bipolartransistor eine Rekombinationsschicht (50) aufgebracht wird, die an das erste Emitterhalbleitergebiet (13) oder das erste Kollektorhalbleitergebiet (11) grenzt und zur Rekombination von Ladungsträger an der Rekombinationsschicht (50) ausgebildet ist, indem
- eine Silizidschicht Rekombinationsschicht oder Metallschicht als Rekombinationsschicht (50) formiert wird,
- eine amorphe Halbleiterschicht sowohl
auf der Rekombinationsschicht (50), als auch
auf einen offen liegenden, an die Rekombinationsschicht (50) angrenzenden, monokristallinen Halbleiterbereich (1)
aufgebracht wird, und
- in einer nachfolgenden Temperaturbehandlung die amorphe Halbleiterschicht ausgehend von dem als Kristallisationskeim wirkenden, offen liegenden, monokristallinen Halbleiterbereich (1) kristallisiert wird, so dass die Rekombinationsschicht (50) zumindest teilweise durch eine kristallisierte, monokristalline Halbleiterschicht (210) bedeckt wird und
- nachfolgend auf die Rekombinationsschicht (50) der zweite Bipolartransistor angeordnet wird, indem
d) ein zweites Emitterhalbleitergebiet (23),
e) ein zweites Basishalbleitergebiet (22) und
f) ein zweites Kollektorhalbleitergebiet (21)
auf der Rekombinationsschicht (50) erzeugt werden, so dass das zweite Emitterhalbleitergebiet (23) oder das zweite Kollektorhalbleitergebiet (21) an die Rekombinationsschicht (50) grenzt.

2. Verfahren nach Anspruch 1, wobei
die Silizidschicht (50) aus Titan als Übergangsmetall und Silizium als Halbleitermaterial gebildet wird.

3. Verfahren nach einem der vorhergehenden Ansprüche, wobei
die amorphe Halbleiterschicht lateral kristallisiert wird.

4. Verfahren nach einem der vorhergehenden Ansprüche, wobei
die Kristallisation in einem Temperaturbereich zwischen 400°C und 600°C erfolgt.

5. Verfahren nach einem der vorhergehenden Ansprüche, wobei
die amorphe Siliziumschicht mit einer Schichtdicke von mindestens 300 nm aufgebracht wird.

6. Verfahren nach einem der vorhergehenden Ansprüche, wobei
zumindest ein Bereich der amorphen Halbleiterschicht mit zumindest einem Dotierstoff, insbesondere mit Germanium, Phosphor, Bor und/oder Arsen dotiert wird.

7. Verfahren nach Anspruch 6, wobei
mit dem Dotierstoff dotierte Bereiche der kristallisierten, monokristallinen Halbleiterschicht (210) selektiv, insbesondere nasschemisch geätzt werden, indem die mit dem Dotierstoff dotierten Bereiche eine gegenüber einem geringer dotierten Bereich der kristallisierten, monokristallinen Halbleiterschicht (210) eine höhere Ätzrate aufweisen.

8. Verfahren nach einem der vorhergehenden Ansprüche, wobei
nach der Kristallisation nicht-monokristalline Bereiche (212) der Halbleiterschicht selektiv entfernt werden.

9. Verfahren nach einem der vorhergehenden Ansprüche, wobei
vorzugsweise nach dem Entfernen der nicht-monokristallinen Bereiche (212) der Halbleiterschicht die monokristalline Schicht (210) durch Epitaxie zur Ausbildung der Halbleitergebiete (21, 22, 23) des zweiten Bipolartransistors verdickt wird.

10. Verfahren nach Anspruch 9, wobei
die monokristalline Schicht (210) durch selektive Epitaxie verdickt wird.

11. Halbleiteranordnung in einem Halbleiterkörper mit
- einem ersten Bipolartransistor und
- einem zweiten Bipolartransistor, die bezüglich der Oberfläche des Halbleiterkörpers (1) vertikal übereinander angeordnet sind
wobei
- ein Emitterhalbleitergebiet (13) des ersten Bipolartransistors und ein Kollektorhalbleitergebiet (21) des zweiten Bipolartransistors an eine Rekombinationsschicht (50) grenzen, die zur Rekombination von Ladungsträgern an den Grenzflächen ausgebildet ist, wobei
- die Rekombinationsschicht (50) eine Metallschicht ist, die von einer monokristallinen Halbleiterschicht (210) bedeckt ist, welche ausgehend von einem als Kristallisationskeim wirkenden, offen liegenden, monokristallinen Halbleiterbereich kristallisiert ist.

12. Halbleiteranordnung nach Anspruch 11, wobei
als Metallschicht Molybden als Rekombinationsschicht (50) aufgebracht ist.

13. Halbleiteranordnung nach einem der Ansprüche 11 oder 12, wobei
zumindest bereichsweise zumindest ein erster PN-Übergang des ersten Bipolartransistors parallel zu zumindest einem zweiten PN-Übergang des zweiten Bipolartransistors ausgebildet ist.

14. Halbleiteranordnung nach einem der Ansprüche 11 bis 13, wobei
die Rekombinationsschicht (50) eine Dicke von weniger als 150 nm aufweist.

15. Halbleiteranordnung nach Anspruch 11, wobei
der erste Bipolartransistor in Emitterschaltung und der zweite Bipolartransistor in Basisschaltung als Kaskodenschaltung verschaltet sind.

16. Halbleiteranordnung nach Anspruch 15, wobei die Rekombinationsschicht (50) über eine elektrisch leitfähige Verbindung mit zumindest einem Anschluss der Bipolartransistoren, einem weiteren integrierten Bauelement und/oder mit einem Anschluss der Kaskodenschaltung verbunden ist.

## Claims

1. Method for integration of two bipolar transistors in a semiconductor body (1), in that
- for the first bipolar transistor
a) a first emitter semiconductor region (13),
b) a first base semiconductor region (12) and
c) a first collector semiconductor region (11)
are produced,
- on the first bipolar transistor a recombination layer (50) is applied, which adjoins the first emitter semiconductor region (13) or the first collecting semiconductor region (11) and is constructed for recombination of charge carriers at the recombination layer (50), in that
- a silicide layer or metal layer is formed as recombination layer (50),
- an amorphous semiconductor layer is applied not only to the recombination layer (50), but also to an exposed monocrystalline semiconductor region (1) adjoining the recombination layer (50) and
- in a subsequent temperature treatment the amorphous semiconductor layer is crystallised starting from the exposed monocrystalline semiconductor region (1), which functions as a crystallisation seed, so that the recombination layer (50) is covered at least partly by a crystallised monocrystalline semiconductor layer (210) and
- subsequently the second bipolar transistor is arranged on the recombination layer (50) in that
d) a second emitter semiconductor region (23),
e) a second base semiconductor region (22) and
f) a second collector semiconductor region (21)
are produced on the recombination layer (50) so that the second emitter semiconductor region (23) or the second collector semiconductor region (21) adjoins the recombination layer (50).

2. Method according to claim 1, wherein the silicide layer (50) is formed from titanium as transition metal and silicon as semiconductor material.

3. Method according to one of the preceding claims, wherein the amorphous semiconductor layer is laterally crystallised.

4. Method according to one of the preceding claims, wherein the crystallisation takes place in a temperature range between 400° C and 600° C.

5. Method according to one of the preceding claims, wherein the amorphous silicon layer is applied with a layer thickness of at least 300 nanometres.

6. Method according to one of the preceding claims, wherein at least one region of the amorphous semiconductor layer is doped with at least one doping substance, particularly with germanium, phosphorus, boron and/or arsenic.

7. Method according to claim 6, wherein regions, which are doped with a doping substance, of the crystallised monocrystalline semiconductor layer (210) are selectively etched, particularly etched wet-chemically, in that the regions doped with the doping substance have a higher etching rate by comparison with a less-doped region of the crystallised monocrystalline semiconductor layer (210).

8. Method according to one of the preceding claims, wherein after the crystallisation non-monocrystalline regions (212) of the semiconductor layer are selectively removed.

9. Method according to one of the preceding claims, wherein preferably after the removal of the non-monocrystalline regions (212) of the semiconductor layer the monocrystalline layer (210) is thickened by epitaxy for formation of the semiconductor regions (21, 22, 23) of the second bipolar transistor.

10. Method according to claim 9, wherein the monocrystalline layer (210) is thickened by a selective epitaxy.

11. Semiconductor arrangement in a semiconductor body with
- a first bipolar transistor and
- a second bipolar transistor, which bipolar transistors are arranged vertically one above the other with respect to the surface of the semiconductor body (1),
wherein
- an emitter semiconductor region (13) of the first bipolar transistor and a collector semiconductor region (21) of the second bipolar transistor adjoin a recombination layer (50) which is formed for recombination of charge carriers at the boundary surfaces, wherein
- the recombination layer (50) is a metal layer covered by a monocrystalline semiconductor layer (210), which is crystallised starting from an exposed monocrystalline semiconductor region acting as a crystallisation seed.

12. Semiconductor arrangement according to claim 11, wherein molybdenum as metal layer is applied as recombination layer (50).

13. Semiconductor arrangement according to one of claims 11 and 12, wherein at least in regions at least one first PN transition of the first bipolar transistor is formed parallel to at least one second PN transition of the second bipolar transistor.

14. Semiconductor arrangement according to one of claims 11 to 13, wherein the recombination layer (50) has a thickness of less than 150 nanometres.

15. Semiconductor arrangement according to claim 11, wherein the first bipolar transistor is connected in emitter connection and the second bipolar transistor in base connection as a cascode circuit.

16. Semiconductor arrangement according to claim 15, wherein the recombination layer (50) is connected by way of an electrically conductive connection with at least one connection of the bipolar transistors, a further integrated component and/or a connection of the cascode circuit.

## Revendications

1. Procédé d'intégration de deux transistors bipolaires dans un corps semi-conducteur (1), selon lequel :
- on réalise pour le premier transistor bipolaire
a) une première zone semi-conductrice d'émetteur (13),
b) une première zone semi-conductrice de base (12) et
c) une première zone semi-conductrice de collecteur (11),
- on dépose sur le premier transistor bipolaire une couche de recombinaison (50), qui est adjacente à la première zone semi-conductrice d'émetteur (13) ou à la première zone semi-conductrice de collecteur (11) et est prévue pour permettre la recombinaison de supports de charge au niveau de la couche de recombinaison (50),
selon lequel
- on forme une couche de silicide ou une couche métallique comme couche de recombinaison (50),
- on dépose une couche semi-conductrice amorphe aussi bien
sur la couche de recombinaison (50) que
sur une zone libre semi-conductrice monocristalline (1), adjacente à la couche de recombinaison (50), et
- on cristallise par un traitement thermique consécutif la couche semi-conductrice amorphe à partir de la zone libre semi-conductrice (1) monocristalline, agissant comme germe cristallin, de sorte que la couche de recombinaison (50) est recouverte au moins partiellement par une couche semi-conductrice (210) monocristalline cristallisée,
- on dispose ensuite le deuxième transistor bipolaire sur la couche de recombinaison (50), en réalisant
d) une deuxième zone semi-conductrice d'émetteur (23),
e) une deuxième zone semi-conductrice de base (22) et
f) une deuxième zone semi-conductrice de collecteur (21)
sur la couche de recombinaison (50), de sorte que la deuxième zone semi-conductrice d'émetteur (23) ou la deuxième zone semi-conductrice de collecteur (21) soit adjacente à la couche de recombinaison (50).

2. Procédé selon la revendication 1, dans lequel la couche de silicide (50) est constituée de titane comme métal de transition et de silicium comme matériau semi-conducteur.

3. Procédé selon l'une quelconque des revendications précédentes, dans lequel la couche semi-conductrice amorphe est cristallisée latéralement.

4. Procédé selon l'une quelconque des revendications précédentes, dans lequel la cristallisation est réalisée dans une plage de températures allant de 400 à 600°C.

5. Procédé selon l'une quelconque des revendications précédentes, dans lequel on dépose la couche de silicium amorphe sur une épaisseur d'au moins 300 nm.

6. Procédé selon l'une quelconque des revendications précédentes, dans lequel on dope au moins une zone de la couche semi-conductrice amorphe avec un dopant, plus particulièrement du germanium, du phosphore, du bore et/ou de l'arsenic.

7. Procédé selon la revendication 6, dans lequel on grave des zones dopées avec une matière dopante de la couche semi-conductrice monocristalline cristallisée (210) de manière sélective, plus particulièrement par un processus chimique par voie humide, les zones dopées avec une matière dopante présentant un taux de gravure plus important par rapport à une zone moins dopée de la couche semi-conductrice monocristalline cristallisée (210).

8. Procédé selon l'une quelconque des revendications précédentes, dans lequel, consécutivement à la cristallisation, on enlève de manière sélective des zones non monocristallines (212) de la couche semi-conductrice.

9. Procédé selon l'une quelconque des revendications précédentes, dans lequel, après avoir enlevé les zones non monocristallines (212) de la couche semi-conductrice, on épaissit la couche monocristalline (210) par épitaxie pour former les zones semi-conductrices (21, 22, 23) du deuxième transistor bipolaire.

10. Procédé selon la revendication 9, dans lequel la couche monocristalline (210) est épaissie par épitaxie sélective.

11. Structure semi-conductrice dans un corps semi-conducteur, comprenant
- un premier transistor bipolaire et
- un deuxième transistor bipolaire, disposés verticalement l'un au-dessus de l'autre par rapport à la surface du corps semi-conducteur (1),
dans laquelle
- une zone semi-conductrice d'émetteur (13) du premier transistor bipolaire et une zone semi-conductrice de collecteur (21) du deuxième transistor bipolaire sont adjacentes à une couche de recombinaison (50), conçue pour la recombinaison de supports de charges au niveau des surfaces limites, dans laquelle
- la couche de recombinaison (50) est une couche métallique, recouverte d'une couche semi-conductrice monocristalline (210), cristallisée à partir d'une zone libre semi-conductrice monocristalline agissant comme germe cristallin.

12. Structure semi-conductrice selon la revendication 11, dans laquelle on dépose comme couche métallique du molybdène pour servir de couche de recombinaison (50).

13. Structure semi-conductrice selon l'une quelconque des revendications 11 ou 12, dans laquelle, au moins dans certaines zones, au moins une première jonction PN du premier transistor bipolaire est conformée parallèle à au moins une deuxième jonction PN du deuxième transistor bipolaire.

14. Structure semi-conductrice selon l'une quelconque des revendications 11 à 13, dans laquelle la couche de recombinaison (50) présente une épaisseur inférieure à 150 nm.

15. Structure semi-conductrice selon la revendication 11, dans laquelle le premier transistor bipolaire monté en émetteur et le deuxième transistor bipolaire monté en base sont montés en circuit cascode.

16. Structure semi-conductrice selon la revendication 15, dans laquelle la couche de recombinaison (50) est reliée par une liaison électrique conductrice à au moins une borne des transistors bipolaires, à un autre composant intégré et/ou à une borne du circuit cascode.
